# EUROPÄISCHE PATENTANMELDUNG

(11) **EP 0 902 469 A2**
(43) Veröffentlichungstag der Anmeldung: **17.03.1999**
(21) Anmeldenummer: 98110737.8
(22) Anmeldetag: 12.06.1998
(51) Int. Cl.: H01L 23/367, H01L 21/48

(54) **Kühlvorrichtung für elektrische bzw. elektronische Bauelemente**

(30) Priorität: 28.08.1997 DE 29715585 U
(71) Anmelder: Hoogovens Aluminium Profiltechnik Bonn GmbH, 53117 Bonn (DE)
(72) Erfinder: Gönner, Johannes, Dipl.-Ing., 53604 Bad Honnef (DE)
(74) Vertreter: Müller, Hans-Jürgen, Dipl.-Ing.

(57) **Zusammenfassung**

Bei einer Kühlvorrichtung für elektrische bzw. elektronische Bauelemente, bei der rippenartige Kühlelemente (3) aus thermisch gut leitfähigem Material dadurch mit einer die zu kühlenden Bauelemente (1a, 1b, 1c) tragende Grundplatte (2) verbunden sind, daß die stegartigen Füße (3a) der Kühlelemente (3) in schlitzartige Längsnuten (4) der Grundplatte (2) verankert sind, wird die Verankerung dadurch verbessert, daß die rillenförmige Vertiefung (4a) in der Längsnutenseitenwand (4c) im freien Querschnitt derart ausgeformt und bemessen ist, daß die bleibende Einformung des Seitenteils des Profilfußes (3a) ohne wesentliche Biegeverformung der aus der Längsnut (4) abstehenden Profilschenkel der Kühlelemente (3) erfolgt.

## Beschreibung

Die Erfindung bezieht sich auf eine Kühlvorrichtung für elektrische bzw. elektronische Bauelemente der im Oberbegriff des Anspruchs 1 genannten Gattung.

Bei einer bekannten Kühlvorrichtung (EP-A-0 696 160) ähnlicher Art werden die rippenartigen Kühlelemente aus thermisch gut leitfähigem Material in schlitzartigen Längsnuten einer Grundplatte verankert, die zur Befestigung der zu kühlenden elektrischen bzw. elektronischen Bauelemente dient. Das Verankern der rippenartigen Kühlelemente in den schlitzartigen Längsnuten erfolgt durch Einklemmen, indem ein langgestrecktes Drahtstück in Bereich des Endes benachbarter Profilschenkel, d.h. des Profilfußes, des rippenartigen Kühlelements so eingepreßt wird, daß das bandförmige Material der Kühlelemente im Bereich dieser Enden an die Längswände der Längsnuten angepreßt wird. Um diese Verankerung zu verbessern, ist auch vorgesehen, die Längsnuten schwalbenschwanzförmig auszubilden. Darüber hinaus wird vorgeschlagen, rillenartige Vertiefungen in den Längsnuten-Seitenwänden vorzusehen.

Darüber hinaus ist es bekannt (EP-A-0 483 058), die Bereiche zwischen benachbarten Längsnuten zu schlitzen und nach dem Einsetzen von als Hohlkörpern ausgebildeten Kühlelementen das Grundplattenmaterial im Bereich der Seitenwände solcher Längsnuten so nach innen zu drücken, daß die Enden der Kühlelemente zwischen den Seitenwänden festgeklemmt werden.

Der Erfindung liegt die Aufgabe zugrunde, mit einfachen Mitteln für eine noch bessere Verankerung der rippenartigen Kühlelemente in der Grundplatte ohne Verbiegen der von dieser abstehenden Teile der Kühlelemente zu sorgen.

Die Erfindung ist im Anspruch 1 gekennzeichnet und in Unteransprüchen sind bevorzugte Ausbildungen derselben beansprucht.

Gemäß der Erfindung werden rillenförmige Vertiefungen in den Längsnuten-Seitenwänden im freien Querschnitt derart ausgeformt und bemessen, daß beim Einformen des betreffenden Seitenteils des Profilfußes keine wesentliche Biegeverformung der aus der Längsnut abstehenden Profilschenkel stattfindet.

Dabei ist es empfehlenswert, wenn die rillenförmigen Vertiefungen im Querschnitt nicht rechteckförmig, sondern derart gekrümmt verlaufen, um daß ein allmählicher Übergang von den im wesentlichen parallelen Seitenwänden in die Vertiefungen und innerhalb der Vertiefungen erfolgt. Der Krümmungsradius sollte etwa dem 0,5- bis 1-fachen der Banddicke der Kühlelemente betragen. Hierdurch wird ein optimales Fließverhalten beim bleibenden Verformen der insbesondere aus Aluminium bestehenden Kühlelemente und zwar beschränkt auf den betreffenden Profilfußbereich im rheologischen Sinne erreicht. Dabei empfiehlt es sich, wenn die Kühlelemente noch in den Längsnuten im Bereich zwischen den rillenförmigen Vertiefungen und der Grundplattenoberfläche, über die sie hinausragen, seitlich abgestützt werden von parallelen Seitenwandteilen der Längsnuten und zwar in genügendem Maße von mindestens dem 1-fachen der Banddicke der Kühlelemente.

Darüber hinaus empfiehlt es sich, wenn die Längsnuten eine Tiefe - in der Grundplatte - zwischen dem 3- und 15-fachen und eine Breite zwischen dem 5- und 20-fachen der Banddicke der Kühlelemente aufweisen.

Besonders günstige Verhältnisse ohne Veränderung der vertikalen Ausrichtung der rippenförmigen Kühlelemente - vertikal von der Grundplattenoberfläche abstehend - werden daher dann erreicht, wenn die Seitenwände der Längsnuten in dieser Vertikalrichtung verlaufen, also im Gegensatz zum Stand der Technik nicht schwalbenschwanzförmig angeordnet sind, und wenn sich die rillenförmigen Vertiefungen sowohl im Abstand vom Nutengrund als auch im Abstand von der Oberfläche der Grundplatte befinden. Hierdurch wird der Gefahr des Verbiegens der aus der Grundplatte herausragenden Teile der Kühlelemente bei deren Einsetzen und Verpressen in den Längsnuten begegnet. Der Abstand der Mitte der rillenförmigen Vertiefungen vom Nutengrund sollte zwischen dem 2- bis 8-fachen der Banddicke der Kühlelemente betragen.

Im übrigen empfiehlt es sich, wenn auch am Nutengrund keine abrupten Übergänge zu den Seitenwänden der Längsnuten vorhanden sind, sondern der Nutengrund mit einem Krummungsradius gerundet in die Seitenwände übergeht, der zwischen dem 1- bis 3-fachen der Banddicke der Kühlelemente beträgt.

Auch der Übergang der Seitenwände in die Grundplattenoberfläche und in die rillenförmigen Vertiefungen sollte mit einem Krümmungsradius erfolgen, der zwischen dem 0,3- und 1-fachen der Banddicke der Kühlelemente beträgt.

Besonders günstige Ergebnisse werden dann erzielt, wenn für das Material der rippenförmigen Kühlelemente, der Grundplatte und der Drahtstücke, die zum bleibenden Fließverformen der Profilfüße und Verklemmen derselben in den Längsnuten dienen, leicht verformbares, thermisch gut leitfähiges Aluminium, z.B. Reinaluminium, verwendet wird. Für die Drahtstücke kann handelsüblicher Aluminiumdraht verwendet werden.

Ausführungsbeispiele für die Erfindung werden nun anhand der Zeichnung näher erläutert. Dabei zeigen:
- Figur 1: eine Kühlvorrichtung nach dem Stand der Technik;
- Figuren 2 und 3: zwei Ausbildungen der Erfindung in schematischer Seitenansicht;
- Figur 4: einen Querschnitt durch einen Teil einer Grundplatte, die mit Längsnuten zur Aufnahme von Kühlelementen versehen ist;
- Figur 5: ein stark vergrößerter Teilausschnitt aus dem Bereich der Verankerung von Kühlelementen in der Längsnut der Grundplatte und
- Figur 6: eine weitere Ausbildung der Erfindung im schematischen Querschnitt.

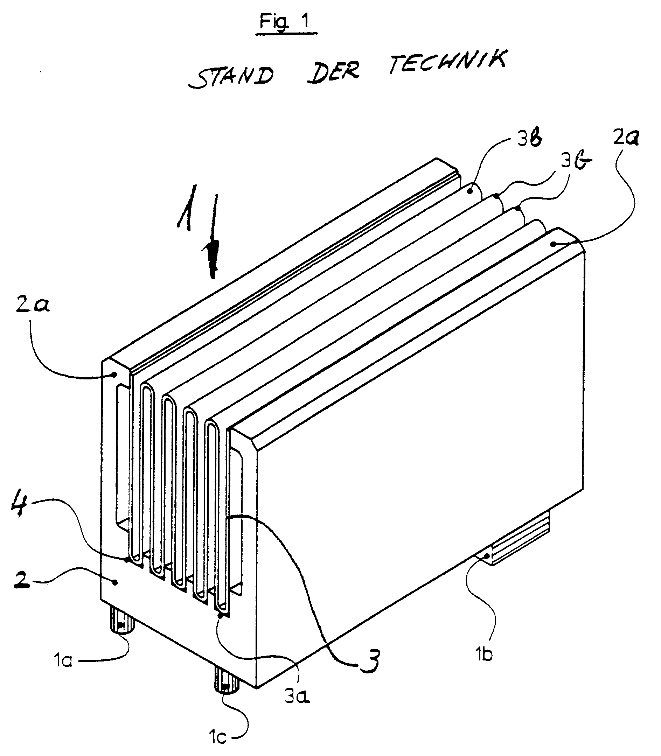

Gemäß Figur 1 sind an der Unterseite einer Grundplatte 2 aus Aluminium, die durch zwei Seitenwände 2a zu einem im Querschnitt etwa U-förmigen Profil ergänzt ist, elektrische und elektronische Bauelemente 1a, 1b, 1c befestigt, die sich im Betrieb erwärmen und deren Wärme auf einfache Weise mittels der Kühlvorrichtung 1 abgeleitet werden soll. Dabei ist die Grundplatte 2 mit in Längsrichtung verlaufenden Längsnuten 4 versehen, in welche die unteren gebogenen Enden 3a von rippenförmigen Kühlelementen 3 eingesetzt sind, deren obere Enden 3b frei abstehen. Sämtliche Kühlelemente 3 der bekannten Kühlvorrichtung bestehen aus einem mäanderförmig geformten Aluminiumband. Die Befestigung der unteren Enden 3a der Kühlelemente 3 in den Längsnuten 4 der Grundplatte 2 erfolgt bei diesem bekannten Beispiel durch Verlöten.

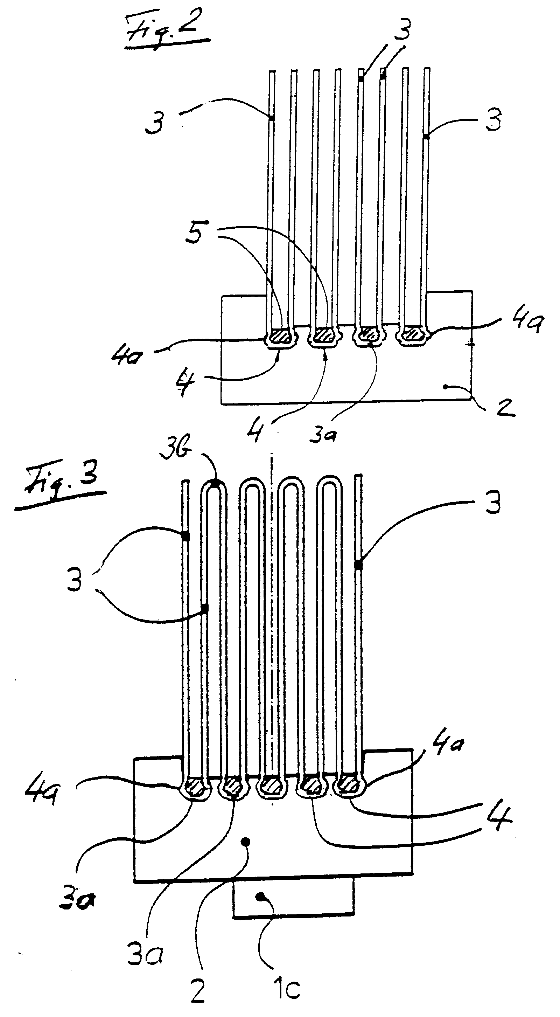

Bei dem Ausführungsbeispiel der Erfindung von Figur 2 werden jeweils zwei Kühlelemente 3 gebildet durch die freien Schenkel eines U-förmigen Bandes aus Reinaluminium. Die die beiden Schenkel verbindenden Stege der Kühlelemente 3 am unteren Ende derselben bilden einen Profilfuß 3a und sind in Längsnuten 4 der Grundplatte 2 eingesetzt. Dabei sind zwischen die beiden Schenkel des jeweiligen U-förmigen Profils Drahtstücke 5 aus Aluminium eingezwängt und durch Anwendung von Druck so verformt, daß die Profilfüße 3a der Kühlelemente 3 etwas seitlich nach außen in die rillenförmigen Vertiefungen 4a in den Seitenwänden 4c der Längsnuten 4 bleibend hineinverformt werden.

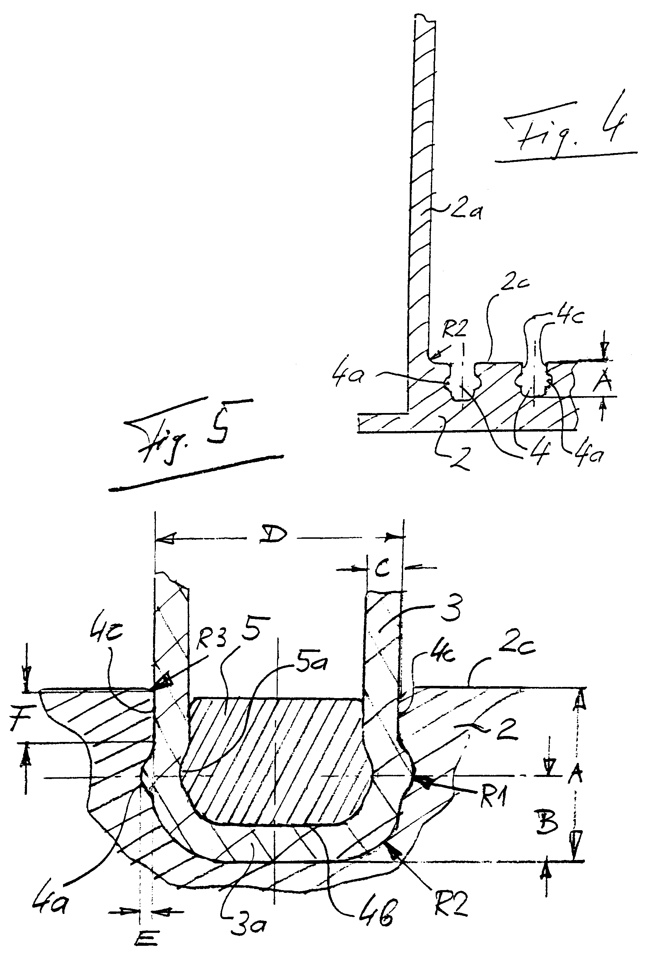

Bei dem Ausbildungsbeispiel von Figur 3 wird gemäß Figur 1 ein mäanderförmig verformtes Band aus Reinaluminium für die Kühlelemente 3 verwendet. Auch hier sind die unteren Enden, d.h. die Profilfüße 3a innerhalb der Längsnuten 4 der Grundplatte 2 so bleibend verformt, daß Material der Kühlelemente 3 in die rillenförmigen Vertiefungen 4a an beiden Seiten der Längsnuten 4 durch Fließpressen bleibend eingeformt ist. Diese Einpreßtechnik führt nicht nur zu einer produktionstechnisch einfachen, sondern auch sicheren Verankerung der Kühlelemente 3 innerhalb der Grundplatte 2, sondern auch zu einem guten Wärmeübergang vom Material der Grundplatte 2 zum Material der Kühlelemente 3, so daß die Kühlfunktion zum Kühlen des elektronischen Bauelements 1c sehr gut erfüllt werden kann.

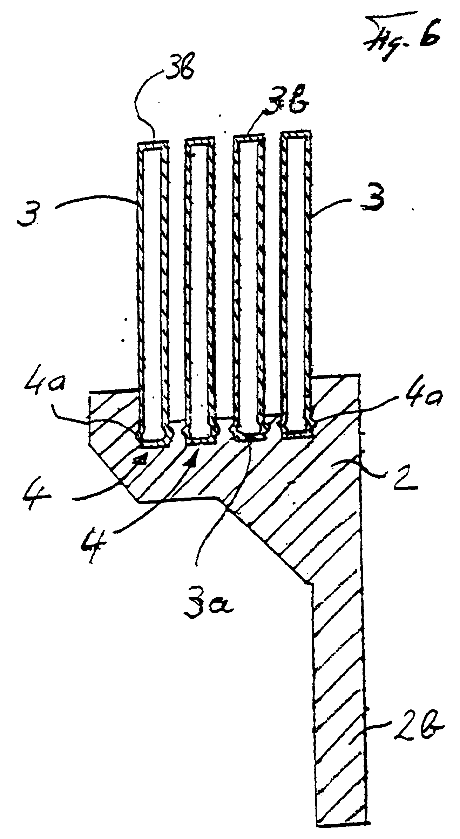

In Figur 4 ist ein Teil einer Grundplatte 2 der Kühlvorrichtung 1 im Querschnitt gezeigt. Dabei weisen die Seitenwände der Längsnuten 4 in Längsrichtung verlaufende rillenförmige Vertiefungen 4a auf. Die Längsnuten 4 ziehen sich bis zu einer Tiefe A von der Oberfläche 2c der Grundplatte 2 in diese hinein. Dieser Oberfläche 2c geht mit einem Krümmungsradius R2 über in die sich vertikal von der Grundplatte 2 nach oben erstreckende Seitenwand 2a der Kühlvorrichtung 1. Bei den Beispielen von Figur 4 sind noch keine Kühlelemente mit der Grundplatte 2 verbunden.

Bei dem vergrößerten Ausführungsbeispiel der Erfindung von Figur 5 ist dagegen das untere Ende, also der Profilfuß 3a eines Kühlelements 3 - beispielsweise von Figur 2 - in der Längsnut 4 der Grundplatte 2 durch Fließpressen fest verankert. Die Mitte der rillenförmigen Vertiefungen 4a in den Seitenwänden 4c der Längsnuten 4 befinden sich in einem Abstand B vom Nutengrund 4b, der mit einem Krümmungsradius R2 in die Seitenwände 4c übergeht. Die rillenförmigen Vertiefungen 4a in den Seitenwänden 4c weisen einen Krümmungsradius R1 auf. Darüber hinaus gehen die Seitenwände 4c zur Oberfläche 2c der Grundplatte 2 gerundet mit einem Krümmungsradius von R3 über. Zwischen die beiden Schenkel des U-förmigen Bauteils, welches die beiden Kühlelemente 3 bildet, ist im Bereich des Profilfußes 3a am unteren Ende und daher auch der Längsnut 4 ein Drahtstück 5 eingepreßt. Durch Druck auf das Drahtstück 5 wird dieses soweit bleibend verformt, daß es das Material der Kühlelemente 3 im Bereich der rillenförmigen Vertiefungen 4a in diese bleibend hinein verformt, ohne daß die aus der Grundplatte 2 herausragenden Teile der rippenförmigen Kühlelemente 3 verformt oder verbogen werden. Das Verformen ist ein Fließpressen. Die rillenförmigen Vertiefungen 4a dringen in die Eindringtiefe E zwischen dem 0,2-fachen und dem 0,8-fachen der Banddicke C in die Grundplatte 2 ein. Die Länge F der parallelen Seitenwandteile zwischen der Oberfläche 2c der Grundplatte 2 und dem Übergang zur rillenförmigen Vertiefung 4a sollte zwischen dem 0,8-fachen und 3-fachen der Banddicke C betragen.

Bei diesem Beispiel werden folgende Vermaßungen bevorzugt:
A = 5,0 mm
B = 2,5 mm
C = 1,0 mm
D = 7,0 mm
E = 0,2 mm
F = 0,4 mm
R1 = 0,8 mm
R2 = 2,0 mm
R3 = 0,5 mm

Auch bei dem Ausführungsbeispiel von Figur 6, das eine weitere Modifikation der Erfindung zeigt, wird ein guter Widerstand gegen Herausreißen von Kühlelementen 3 aus den Längsnuten 4 dadurch erzielt, daß die Profilfuße 3a der dünnen, hier hohlförmigen Kühlelemente 3 durch Stauchkräfte in die bei diesem Beispiel einen etwas größeren Krümmungsradius R1 und/oder eine größere Eindringtiefe E aufweisenden rillenförmigen Vertiefungen 4a hineingestaucht sind. Dies kann dadurch geschehen, daß die hohlkastenförmigen Kühlelemente 3 von einem Führungswerkzeug gefaßt und in die Längsnuten 4 derart eingepreßt werden, daß sich die aus der Grundplatte 2 herausragenden Teile der Kühlelemente 3 nicht verformen. Das Führungswerkzeug ist bei diesem Beispiel (nicht gezeigt) im Querschnitt kammartig, so daß die Zähne des Kammes zwischen benachbarte Kühlelemente 3 eingreifen und die Wandungen dort abstützen.

Es hat sich gezeigt, daß sich Materialdicken bzw. Banddicken C zwischen 0,5 mm und 1,5 mm für die Kühlelemente 3 besonders bewährt haben. Im Falle der Verwendung von Materialien, wie Al ergeben sich gute Verformungseigenschaften zum Einformen in die rillenförmigen Vertiefungen 4a.

## Patentansprüche

1. Kühlvorrichtung für elektrische bzw. elektronische Bauelemente
mit einer Grundplatte (2) zur Befestigung der zu kühlenden Bauelemente (1a, 1b, 1c) und
mit rippenartigen Kühlelementen (3) aus thermisch gut leitfähigem Material,
bei der die Kühlelemente (3) im wesentlichen parallel zueinander und im Abstand voneinander in wärmeübertragendem Kontakt mit der Grundplatte (2) verbunden und mindestens je zwei Kühlelemente (3) zu einer einstückigen bandförmigen Baueinheit zusammengefaßt sind, die im Querschnitt z.B. ein U-förmiges Profil aufweist, dessen stegartiger Fuß (3a) in eine schlitzartige Längsnut (4) in der Grundplatte (2) eingreift und dort mindestens teilweise durch derartige bleibende Verformung verankert ist, daß mindestens ein verformter Seitenteil des Fußes (3a) in eine sich im wesentlichen in Längsrichtung der Längsnut (4) erstreckende rillenförmige Vertiefung (4a) in einer Seitenwand (4c) der Längsnut (4) eingedrückt ist,
**dadurch gekennzeichnet,**
daß die rillenförmige Vertiefung (4a) in der Längsnuten-Seitenwand (4c) im freien Querschnitt derart ausgeformt und bemessen ist, daß die bleibende Einformung des Seitenteils des Profilfußes (3a) der Kühlelemente (3) ohne wesentliche Biegeverformung der aus der Längsnut (4) abstehenden Profilschenkel der Kühlelemente (3) erfolgt.

2. Kühlvorrichtung nach Anspruch 1,
**dadurch gekennzeichnet,**
daß die rillenförmige Vertiefung (4a) einen Krümmungsradius (R1) aufweist, der etwa dem 0,5- bis 1-fachen der Banddicke (C) der Kühlelemente (3) beträgt.

3. Kühlvorrichtung nach Anspruch 1 oder 2,
**dadurch gekennzeichnet,**
daß sich der Übergang zur rillenförmigen Vertiefung (4a) in einem Abstand (F) von der Oberfläche (2c) der Grundplatte (2) befindet, der zwischen dem 0,4-fachen und 3-fachen der Banddicke (C) der Kühlelemente (3) beträgt.

4. Kühlvorrichtung nach einem der vorhergehenden Ansprüche,
**dadurch gekennzeichnet,**
daß die Längsnuten-Seitenwände (4c) zwischen der Oberfläche (2c) der Grundplatte (2) und den rillenförmigen Vertiefungen (4a) im wesentlichen parallel verlaufen.

5. Kühlvorrichtung nach Anspruch 4,
**dadurch gekennzeichnet,**
daß die Übergänge von der Oberfläche (2c) der Grundplatte (2) zu den Längsnuten-Seitenwänden (4c) sowie von diesen in die rillenförmigen Vertiefungen (4a) nicht scharfkantig, sondern abgerundet geformt sind.

6. Kühlvorrichtung nach Anspruch 5,
**dadurch gekennzeichnet,**
daß die Seitenwände (4c) mit einem Krümmungsradius (R3) in die Oberfläche (2c) der Grundplatte (2) übergeht, der zwischen dem 0,3- und 1-fachen der Banddicke (C) der Kühlelemente (3) beträgt.

7. Kühlvorrichtung nach einem der vorhergehenden Ansprüche,
**dadurch gekennzeichnet,**
daß die Längsnuten (4) eine Tiefe (A) zwischen dem 3-bis 15-fachen und eine Breite zwischen dem 5- und 20fachen der Banddicke (C) der Kühlelemente (3) aufweisen.

8. Kühlvorrichtung nach einem der vorhergehenden Ansprüche,
**dadurch gekennzeichnet,**
daß sich die Mitte der rillenförmigen Vertiefungen (4a) in einem Abstand (B) vom Nutengrund (4b) der Längsnuten (4) befindet, der zwischen dem 2- bis 8-fachen der Banddicke (C) der Kühlelemente (3) beträgt.

9. Kühlvorrichtung nach einem der vorhergehenden Ansprüche,
**dadurch gekennzeichnet,**
daß der Nutengrund (4b) mit einem Krümmungsradius (R2) gerundet in die Seitenwände (4c) der Längsnuten (4) übergeht, der zwischen dem 1- und 3-fachen der Banddicke (C) der Kühlelemente (3) beträgt.

10. Kühlvorrichtung nach einem der vorhergehenden Ansprüche,
**dadurch gekennzeichnet,**
daß die Kühlelemente (3) und/oder die Grundplatte (2) aus Aluminium bestehen.

11. Kühlvorrichtung nach einem der vorhergehenden Ansprüche,
**dadurch gekennzeichnet,**
daß der Profilfuß (3a) eines bleibend verformbaren Drahtstücks (5) aus Aluminium in die rillenförmige Vertiefung (4a) durch bleibende Verformung fließend eingepreßt ist.
